(19) Europäisches Patentamt
European Patent Office
Office européen des brevets

(11) **EP 0 940 862 A2**

(12) **EUROPÄISCHE PATENTANMELDUNG**

(43) Veröffentlichungstag:
08.09.1999 Patentblatt 1999/36

(51) Int. Cl.$^6$: **H01L 39/14**

(21) Anmeldenummer: 99103534.6

(22) Anmeldetag: 23.02.1999

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **06.03.1998 DE 19809766**

(71) Anmelder:
**SIEMENS AKTIENGESELLSCHAFT**
**80333 München (DE)**

(72) Erfinder:
**Jenovelis, Alexander, Dipl.-Ing.**
**91080 Spardorf (DE)**

(54) **Bandförmiger Multifilamentsupraleiter mit Bi-Cuprat-Filamenten**

(57) Der bandförmige Multifilamentsupraleiter (10) weist mindestens 10 in eine Ag-Matrix (12) eingebettete supraleitende Filamente (11i) auf, die ein Bi-Cuprat mit der Hoch-$T_c$-Phase vom 2223-Typ enthalten. Um eine hohe kritische Stromdichte ($J_c$) zu ermöglichen, sollen wenigstens einige Filamente (11i) einen Formfaktor $F = \pi^2 \cdot d_f/4b_f$ (mit $d_f$ = Filamentdicke und $b_f$ = Filamentbreite) haben, der höchstens 0,03 beträgt.

FIG 3

**Beschreibung**

Die Erfindung bezieht sich auf einen bandförmigen Multifilamentsupraleiter mit mindestens zehn supraleitenden Filamenten, wobei über den Leiterquerschnitt gesehen in Richtung der Leiterbreite und der Leiterdicke jeweils mehrere untereinander beabstandete Filamente vorhanden sind, die jeweils zumindest teilweise ein Bi-Cuprat mit einer Hoch-$T_c$-Phase vom 2223-Typ aufweisen, von einem normalleitenden Ag-Matrixmaterial umgeben sind und einen vorbestimmten Formfaktor F besitzen, wobei der Formfaktor F definiert durch die Beziehung $F = \pi^2 \cdot d_f/4b_f$ mit $d_f$ = Dicke und $b_f$ = Breite des jeweiligen Filamentes. Ein entsprechender Multifilamentsupraleiter geht z.B. aus der Veröffentlichung *„IEEE Transactions on Applied Superconductivity", Vol. 7, No. 2, Juni 1997, Seiten 355 bis 358* hervor.

Es sind supraleitende Metalloxidverbindungen mit hohen Sprungtemperaturen $T_c$ von über 77 K bekannt, die deshalb auch als Hoch-$T_c$-Supraleitermaterialien oder HTS-Materialien bezeichnet werden und insbesondere eine Flüssig-Stickstoff($LN_2$)-Kühltechnik erlauben. Unter solche Metalloxidverbindungen fallen insbesondere Cuprate auf Basis des Wismut-Stoffsystems Bi-Sr-Ca-Cu-O oder Bi(Pb)-Sr-Ca-Cu-O. Innerhalb dieser wismuthaltigen Stoffsysteme treten mindestens zwei supraleitende Phasen auf, die sich durch die Anzahl ihrer Kupfer-Sauerstoff-Netzebenen (bzw. -Schichten) innerhalb der kristallinen Einheitszelle unterscheiden. Eine supraleitende Phase mit der ungefähren Zusammensetzung $Bi_2Sr_2CaCu_2O_{8+y}$ hat eine Sprungtemperatur $T_c$ von etwa 85 K (sogenannter 2-Schichter oder sogenannte 85 K- bzw. 2212-Phase), während die Sprungtemperatur einer supraleitenden Phase mit der ungefähren Zusammensetzung $Bi_2Sr_2Ca_2Cu_3O_{10+x}$ bei etwa 110 K liegt (sogenannter 3-Schichter oder sogenannte 110 K- bzw. 2223-Phase).

Mit diesen bekannten HTS-Materialien wird versucht, langgestreckte Supraleiter insbesondere in Bandform herzustellen. Ein hierfür als geeignet angesehenes Verfahren ist die sogenannte „Pulver-im-Rohr-Technik", die prinzipiell von der Herstellung von Supraleitern mit dem klassischen metallischen Supraleitermaterial $Nb_3Sn$ her bekannt ist. Entsprechend dieser Technik wird auch zur Herstellung von Leitern aus HTS-Material in eine rohrförmige Umhüllung bzw. in eine Matrix aus einem normalleitenden Material, insbesondere aus Ag oder einer Ag-Legierung, ein im allgemeinen pulverförmiges Vormaterial des HTS-Materials eingebracht, das im allgemeinen noch nicht oder nur zu einem geringen Teil die gewünschte supraleitende Hoch-$T_c$-Phase enthält. Der so zu erhaltende Aufbau wird anschließend in verschiedenen Verformungsschritten, die gegebenenfalls durch eine Wärmebehandlung bei erhöhter Temperatur unterbrochen sein können, auf eine gewünschte Dimension eines Leitervorproduktes gebracht.

Bündelt man dann in an sich bekannter Weise mehrere solcher im allgemeinen drahtförmigen Leitervorprodukte in einer Umhüllung und verformt den so gewonnenen Aufbau, so erhält man einen Rohleiter mit entsprechender Anzahl von Leiterkernen, die über den Leiterquerschnitt gesehen in Richtung der Leiterbreite und der Leiterdicke untereinander beabstandet sind und im allgemeinen eine annähernd gleichmäßige Verteilung über den Leiterquerschnitt aufweisen. Dieser Rohleiter wird weiteren Verformungsschritten und Einschluß von Flachbearbeitungsschritten wie Walzen und sowie mindestens einem Glühschritt unterzogen, um so einen bandförmigen Multifilamentsupraleiter zu erhalten. Für derartige Multifilamentsupraleiter werden bevorzugt Filamente aus der Hoch-$T_c$-Phase vom 2223-Typ vorgesehen (vgl. z.B. *„Applied Superconductivity", Vol. 2, No. 3/4, 1994, Seiten 155 bis 162* oder *„Applied Superconductivity", Vol. 3, No. 1-3, 1995, Seiten 1 bis 5*).

Bei dem aus der eingangs genannten Literaturstelle zu entnehmenden Multifilamentsupraleiter mit 55 die Bi-2223-Phase enthaltenden Filamenten liegt dabei der Formfaktor F der einzelnen Filamente zwischen etwa 0,05 und 0,2. Unter dem Formfaktor wird dabei die Beziehung $F = \pi^2 \cdot d_f/4b_f$ verstanden, wobei $d_f$ die Dicke und $b_f$ die Breite des jeweiligen Filamentes sind. Der bekannte Multifilamentsupraleiter hat bei 77 K und fehlendem äußeren Magnetfeld (Nullfeld) eine kritische Stromdichte $J_c$ (bzw. Stromtragfähigkeit) unter Zugrundelegung des sogenannten 1 $\mu$V/cm-Kriteriums von bis zu 33 kA/cm$^2$. Für einen großtechnischen Einsatz von Multifilamentsupraleitern werden im allgemeinen jedoch höhere kritische Stromdichten gefordert.

Aus der *DE 196 21 070 A1* geht ferner ein bandförmiger Hoch-$T_c$-Multifilamentsupraleiter hervor, dessen mehr als zehn Leiterfilamente ein sogenanntes Aspektverhältnis von bis zu 80 aufweisen können, was einem Formfaktor F (gemäß der vorstehenden Definition) von etwa 0,031 entspricht. Bei diesem bekannten Supraleiter wird eine hohe kritische Stromdichte $J_c$ von über 50 kA/cm$^2$ (bei 77 K, im Nullfeld) dadurch erreicht, daß Leiterbereiche mit Matrixmaterial unterschiedlicher Härte vorgesehen werden. Der entsprechende Aufbau des Supraleiters erfordert jedoch einen verhältnismäßig hohen Aufwand.

Ein weiterer bandförmiger Hoch-$T_c$-Multifilamentsupraleiter geht aus der EP 0 747 975 A1 hervor. Dieser Leiter soll hergestellt werden, indem zunächst bandförmige Leiterelemente mit mindestens einem in ein normalleitendes Matrixmaterial eingebetteten Leiterkern aus einem Vormaterial des Supraleitermaterials erstellt werden. Diese Leiterelemente werden dann in einem Ofen mechanisch zusammengehalten und geglüht, wobei sie an ihren Berührungsflächen zu einem Verbundaufbau verschweißen. Dieser Verbundaufbau wird dann weiter verformt und geglüht. Das so mit dem bekannten Verfahren zu erhaltende Endprodukt weist in mehreren, insbesondere zwei bis neun Lagen stapelartig übereinanderliegende, untereinander beabstandete Leiterkerne in dem Matrixmaterial auf. In jeder Lage des Stapels befindet sich dabei ein einziger Leiterkern in Bandform mit einem hohen Aspektverhältnis von über 50. Während der Herstellung dieses Leiters kann jedoch bei der Verformung des aus mehreren Leiterelementen zusammengeschweißten Verbundaufbaus insbesondere bei höheren Verformungsgraden die Verschweißung benachbarter Leiterelemente aufreißen. Der Verformungsgrad ist deshalb begrenzt. Dies führt dazu, daß die einzelnen Leiterkerne in dem Leiterendprodukt noch verhältnismäßig dick sein müssen und deshalb nur eine entsprechend beschränkte kritische Stromdichte ermöglichen.

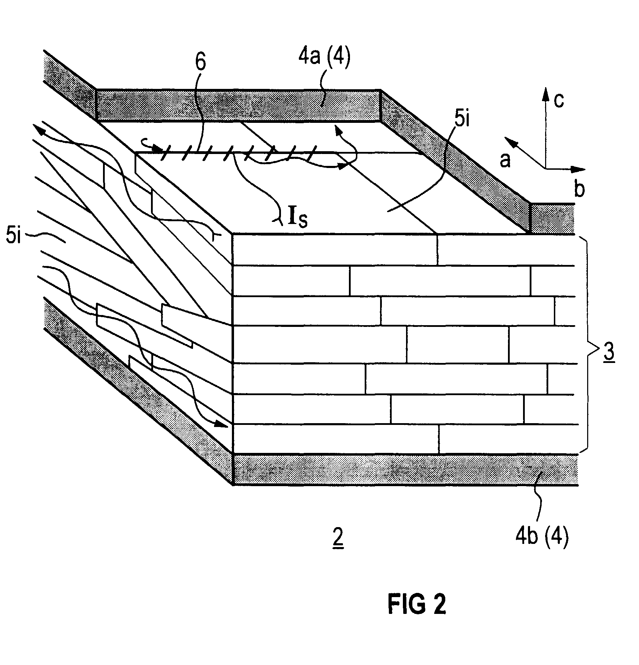

Aufgabe der vorliegenden Erfindung ist es, den bandförmigen Multifilamentsupraleiter mit den eingangs genannten Merkmalen dahingehend auszugestalten, daß eine hohe kritische Stromdichte $J_c$ von mindestens 50 kA/cm$^2$ auf verhältnismäßig einfache Weise erreichbar ist. Der Multifilamentsupraleiter soll insbesondere nach einer üblichen Bündelungstechnik zu erstellen sein, womit auf verhältnismäßig einfache Weise über den Leiterquerschnitt gesehen in Richtung der Leiterbreite und der Leiterdicke jeweils mehrere untereinander beabstandete Filamente zu erhalten sein sollen. Dabei soll zu erreichen sein, daß jeweils benachbarte Filamente in einer gemeinsamen Filamentebene nebeneinander und/oder in parallelen Filamentebenen übereinander und/oder schräg seitlich versetzt angeordnet sind (vgl. z.B. Figur 2 der DE 196 21 070 A1).

Diese Aufgabe wird erfindungsgemäß dadurch gelöst, daß der Formfaktor zumindest einiger Filamente des Supraleiters unter 0,03, vorzugsweise unter 0,025 liegt.

Es wurde nämlich erkannt, daß insbesondere für kritische Stromdichten oberhalb von 50 kA/cm$^2$ ein vorbestimmter geringer Formfaktor der einzelnen Filamente die entscheidende Größe ist. Die mit der Erfindung verbundenen Vorteile sind folglich darin zu sehen, daß durch die Wahl der vorbestimmten geringen Formfaktoren zumindest für einzelne Filamente eines bandförmigen, verhältnismäßig einfach herzustellenden Multifilamentsupraleiters kritische Stromdichten $J_c$ zu erhalten sind, die deutlich über denen von bekannten Multifilamentsupraleitern liegen.

Besonders vorteilhaft ist es für den bandförmigen Multifilamentsupraleiter, wenn zumindest einige seiner Filamente eine Breite aufweisen, die mehr als 80 mal, vorzugsweise mehr als 90 mal größer ist als die Dicke des jeweiligen Filamentes. Denn dann ist eine besonders hohe kritische Stromdichte möglich. Dies ist für den bandförmigen Multifilamentsupraleiter insbesondere dann zu gewährleisten, wenn mehr als die Hälfte der Filamente dem vorbestimmten Formfaktor genügen.

Die Anordnung der einzelnen Filamente über den Leiterquerschnitt gesehen kann vorteilhaft so vorgesehen sein, daß in mehreren (gedachten) Filamentebenen jeweils mehrere Filamente vorhanden sind. Dabei können insbesondere in jeder Filamentebene mindestens drei Filamente vorhanden sein. Ein derartiger Aufbau eines Multifilamentsupraleiters läßt sich in einfacher Weise mittels einer Bündelungstechnik von rechteckigen Leitervorprodukten, die mindestens einen Leiterkern aus einem Vormaterial des Supraleitermaterials aufweisen, innerhalb einer Umhüllung sowie mittels Verformungs- und Glühschritten der so verfüllten Umhüllung gewinnen. Dabei ist die Gefahr von Brüchen der einzelnen Filamente auch bei vorteilhaft geringen Filmdicken weitgehend auszuschließen, so daß die Voraussetzungen für eine hohe kritische Stromdichte gegeben sind.

Weitere vorteilhafte Ausgestaltungen des erfindungsgemäßen Multifilamentsupraleiters gehen aus den übrigen abhängigen Ansprüchen hervor.

Die Erfindung wird nachfolgend anhand der Zeichnung noch weiter erläutert. Dabei zeigen jeweils schematisch

| | |
|---|---|
| deren Figur 1 | einen Teil eines Querschnitts durch einen bekannten Multifilamentsupraleiter, |
| deren Figur 2 | eine Schrägansicht auf einen Ausschnitt aus einem erfindungsgemäßen Multifilamentsupraleiter und |
| deren Figur 3 | einen Querschnitt durch einen erfindungsgemäßen Multifilamentsupraleiter. |

In den Figuren sind sich entsprechende Teile mit denselben Bezugszeichen versehen.

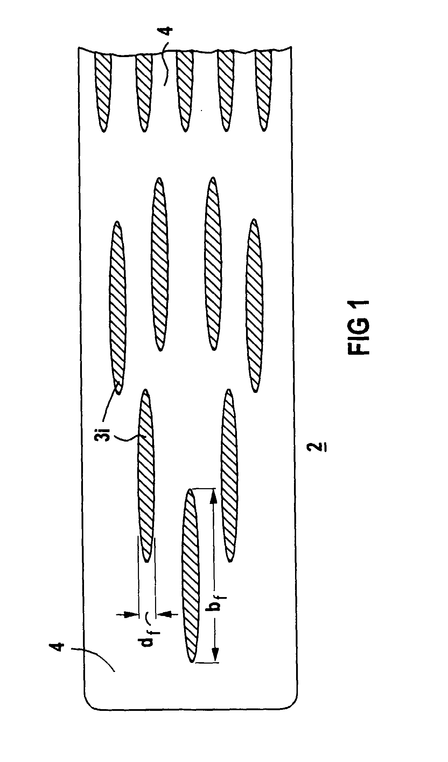

In Figur 1 ist eine Teilansicht des Querschnitts durch einen an sich bekannten bandförmigen HTS-Multifilamentleiter veranschaulicht (vgl. z.B. die genannte DE 196 21 070 A1). Der mit 2 bezeichnete, etwa zur Hälfte dargestellte HTS-Multifilamentleiter hat z.B. 19 supraleitende Leiterfilamente 3i aus einem vorbestimmten HTS-Material in einer normalleitenden Matrix 4. Die Leiterfilamente sollen als Supraleitermaterial das bekannte Bi-Cuprat mit der 2223-Phase zumindest großenteils, d.h. zu mehr als 50 % enthalten. Dabei kann die Bi-Komponente in bekannter Weise durch Pb teilweise substituiert sein. Als Matrixmaterial dient Ag entweder in reiner Form oder in Form einer Legierung mit Ag als Hauptbestandteil, d.h. zu mehr als 50 Gew.-%, oder auch in einer anderen, Ag-haltigen Form (vgl. auch die vorgenannte DE-A-Schrift). Jedes Leiterfilament 3i hat eine Filamentbreite $b_f$ und eine maximale Filamentdicke $d_f$, wobei diese Größen im allgemeinen über den Querschnitt des Gesamtleiters 2 gesehen voneinander abweichende Werte haben können. Aus Gründen einer übersichtlicheren Darstellung sind gleiche Querschnitte der einzelnen Leiterfilamente 3i angenommen, wobei die Dicke $d_f$ verhältnismäßig groß gewählt ist. Erfindungsgemäß sollen jedoch die Größen $b_f$ und $d_f$ zumindest einiger Filamente 3i des Leiters, vorzugsweise von mehr als der Hälfte aller Filamente in einer bestimmten, durch einen Formfaktor F definierten Relation stehen.

Allgemein ist der Formfaktor $F^*$ eines Filaments mit runder Querschnittsfläche A folgendermaßen definiert:

$$F^* = 4\pi \cdot A/U^2,$$

wobei U der Umfang des kreisförmigen Filamentes ist. Ausgehend von dieser Beziehung für den Formfaktor ergibt sich für Filamente in bandförmigen Multifilamentsupraleitern für den Formfaktor F ungefähr die folgende, bei dem erfindungsgemäßen Leiter anzunehmende Beziehung:

$$F = 4\pi \cdot (d_f b_f \cdot \pi/4)/(2b_f)^2$$
$$= \pi^2 d_f/4b_f,$$

wobei $b_f$ die Filamentbreite und $d_f$ die Filamentdicke sind. Geht man für die geforderte hohe kritische Stromdichte $J_c$ von einem Formfaktor F von unter 0,03 der Bandfilamente aus, so bedeutet das, daß die Filamentbreite $b_f$ etwa mindestens das 82-fache der Filamentdicke $d_f$ betragen muß. D.h. ein etwa 10 μm dickes Filament müßte dann eine Breite von etwas über 0,8 mm haben. Bei dem erfindungsgemäßen bandförmigen Multifilamentsupraleiter sollen zumindest einige, vorzugsweise mindestens die Hälfte aller Filamente diese Beziehung zwischen der Filamentbreite und der Filamentdicke erfüllen. Besonders vorteilhaft werden Filamente vorgesehen, deren Breite $b_f$ mindestens 90 mal größer ist als ihre maximale Dicke $d_f$. Das entspräche einem Formfaktor F von etwa 0,0275. Generell sind möglichst kleine Formfaktoren F anzustreben, wobei Filamente mit Dicken unter 20 μm, vorzugsweise von höchstens 10 μm von Vorteil sind, die im allgemeinen durch Walzschritte eingestellt werden. Die untere Grenze der Dicke wird durch das Auftreten von Rissen beim Verformungsprozeß festgelegt.

Aus Figur 2 ist eine plausible Erklärung für den gewählten Wert des Formfaktors eines Leiterfilamentes abzuleiten. Die Figur zeigt einen Ausschnitt aus einem bandförmigen Multifilamentsupraleiter 2 nach der Erfindung im Bereich eines Leiterfilamentes 3, das zwischen normalleitendes Material 4a und 4b einer Ag-Matrix 4 eingebettet ist. Das Leiterfilament ist dabei aus einzelnen Kristalliten 5i aus der Bi-2223-Phase zusammengesetzt. Die Kristallite dieser Phase sind im allgemeinen weitgehend plättchenförmig, wobei die Flachseiten dieser Kristallite in der kristallinen a-b-Ebene eines rechtwinkligen a-b-c-Koordinatensystems liegen. Wenn nun ein in der Figur durch gepfeilte Linien veranschaulichter Suprastrom $I_s$ aufgrund eines zwischen benachbarten Kristalliten 5i ausgebildeten „Weak links" 6 (= sehr schmaler Bereich mit geschwächter Supraleitfähigkeit, insbesondere durch Korngrenzen verursacht) nicht ohne weiteres in der kristallographischen a-Richtung weiterfließen kann, so wird er zu einem Umweg über die genauso gut leitende b-Richtung gezwungen. Voraussetzung dafür ist aber, daß das Filament 3 eine hinreichende Breite $b_f$ besitzt. D.h., nicht nur die Dicke $d_f$ eines Filamentes ist ein kritischer Parameter, sondern es kommt im Hinblick auf eine hinreichend hohe kritische Stromdichte auch auf die Breite des Filamentes an. Mit der erfindungsgemäßen Bemessungsregel ist dieser Überlegung Rechnung getragen.

Da die kristallographische a-Richtung gegenüber der b-Richtung nicht eindeutig ausgezeichnet ist, gilt die vorstehende Betrachtung der Stromführung auch für den analogen Fall, daß in b-Richtung ein Strom fließen soll und zu einem Umweg über die a-Richtung gezwungen wird.

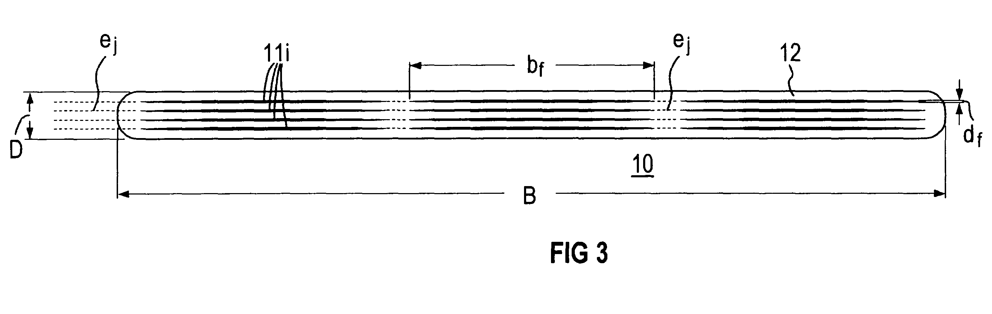

Die Anordnung der einzelnen Leiterfilamente über den Querschnitt des bandförmigen Endproduktes eines erfindungsgemäßen Multifilamentsupraleiters soll immer so vorgenommen sein, daß bei einer Unterteilung des Leiterquerschnitts in Richtung der Leiterbreite in mehrere nebeneinanderliegende, gedachte Leiterabschnitte in jedem dieser Leiterabschnitte mindestens ein Filament angeordnet ist. Im allgemeinen sind zumindest in einigen dieser Abschnitte mehrere Filamente vorhanden. Seitlich benachbarte Elemente brauchen dabei nicht unbedingt in einer gemeinsamen, gedachten Filamentebene parallel zu der oberen oder unteren Flachseite des Leiters zu liegen (vgl. z.B. Figur 2 der genannten DE 196 21 070 A1). Vorteilhaft ist es jedoch, wenn mehrere solcher gedachten Filamentebenen vorhanden sind, in denen sich jeweils mehrere nebeneinander angeordnete Filamente befinden. Ein entsprechendes konkretes Ausführungsbeispiel eines bandförmigen Multifilamentleiters geht aus Figur 3 hervor.

Figur 3 zeigt einen Querschnitt durch einen solchen, allgemein mit 10 bezeichneten Multifilamentsupraleiter mit einer Bandbreite B von etwa 2,8 mm und einer Banddicke D von etwa 0,16 mm. Der Leiter 10 weist 16 Leiterfilamente 11i in 4 Filamentebenen $e_j$ (mit j = 1 bis 4) auf, wobei in jeder Filamentebene 3 Filamente 11i nebeneinander und untereinander beabstandet angeordnet sind. Die Filamente 11i bestehen zumindest weitgehend aus Bi-Cuprat mit der supraleitenden Hoch-$T_c$-Phase vom 2223-Typ. Sie sind von einer Matrix 12 aus reinem Ag oder einem mindestens zu 50 % Ag enthaltenden Material in Form einer Verbindung, Legierung oder anderen Zusammensetzung umgeben. Jedes Filament hat eine Filamentbreite $b_f$ von etwa 0,84 mm und eine Filamentdicke $d_f$ von etwa 10 μm. Es ergibt sich dann ein Formfaktor F von unter 0,03. Der Füllfaktor dieses Multifilamentleiters, d.h. der Anteil an supraleitendem Material, beträgt dabei etwa 23 %. Ein derartiger Multifilamentleiter ermöglicht eine kritische Stromdichte von mindestens 50 kA/cm$^2$.

## Patentansprüche

1. Bandförmiger Multifilamentsupraleiter mit mindestens zehn supraleitenden Filamenten, wobei über den Leiterquerschnitt gesehen in Richtung der Leiterbreite und der Leiterdicke jeweils mehrere untereinander beabstandete Filamente vorhanden sind, die jeweils

   - zumindest teilweise ein Wismut(Bi)-Cuprat mit einer Hoch-$T_c$-Phase vom 2223-Typ aufweisen,
   - von einem normalleitenden Ag-Matrixmaterial umgeben sind und
   - einen vorbestimmten Formfaktor F besitzen, wobei der Formfaktor F definiert ist durch die Beziehung $F = \pi^2 \cdot d_f/4b_f$ mit $d_f$ = Dicke und $b_f$ = Breite des jeweiligen Filamentes, **dadurch gekennzeichnet,** daß der Formfaktor F zumindest einiger Filamente (3, 3i, 11i) unter 0,03, vorzugsweise unter 0,025 liegt.

2. Supraleiter nach Anspruch 1, **dadurch gekennzeichnet,** daß zumindest einige Filamente (3, 3i, 11i) eine Breite ($b_f$) aufweisen, die mehr als 80 mal, vorzugsweise mehr als 90 mal größer ist als die Dicke ($d_f$) des jeweiligen Filamentes.

3. Supraleiter nach Anspruch 1 oder 2, **dadurch gekennzeichnet,** daß zumindest einige Filamente (3, 3i, 11i) eine Dicke ($d_f$) aufweisen, die unter 20 $\mu$m liegt und vorzugsweise höchstens 10 $\mu$m beträgt.

4. Supraleiter nach einem der vorangehenden Ansprüche, **dadurch gekennzeichnet,** daß mehr als die Hälfte der Filamente (3, 3i, 11i) dem vorbestimmten Formfaktor F genügen.

5. Supraleiter nach einem der vorangehenden Ansprüche, **dadurch gekennzeichnet,** daß über den Leiterquerschnitt gesehen in mehreren Filamentebenen ($e_j$) jeweils mehrere Filamente (11i) vorhanden sind.

6. Supraleiter nach Anspruch 5, **dadurch gekennzeichnet,** daß in jeder Filamentebene ($e_j$) jeweils mindestens drei Filamente (11i) vorhanden sind.

7. Supraleiter nach einem der vorangehenden Ansprüche, **dadurch gekennzeichnet,** daß als Matrixmaterial (4a, 4b) Ag oder eine Ag-Legierung vorgesehen ist.

8. Supraleiter nach einem der vorangehenden Ansprüche, **dadurch gekennzeichnet,** daß die Bi-Komponente des Bi-Cuprats teilweise durch Pb substituiert ist.

9. Supraleiter nach einem der vorangehenden Ansprüche, **gekennzeichnet** durch eine kritische Stromdichte bei 77 K im Nullfeld von mindestens 50 kA/cm$^2$.

FIG 1

**FIG 2**

**FIG 3**

EP 0 940 862 A2